# EUROPEAN PATENT APPLICATION

(11) **EP 4 068 628 A1**
(43) Date of publication of application: **05.10.2022**
(21) Application number: 20879253.1
(22) Date of filing: 06.05.2020
(51) Int. Cl.: H03H 9/02

(54) **BULK ACOUSTIC RESONATOR WITH ELECTRODE HAVING VOID LAYER, AND FILTER AND ELECTRONIC DEVICE**

(30) Priority: 23.10.2019 CN 201911009262; 26.10.2019 CN 201911027013
(71) Applicant: Rofs Microsystem (Tianjin) Co., Ltd, Tianjin 300462 (CN)
(72) Inventor: PANG, Wei, Tianjin 300072 (CN); ZHANG, Menglun, Tianjin 300072 (CN); XU, Yang, Tianjin 300462 (CN); YANG, Qingrui, Tianjin 300072 (CN)
(74) Representative: Meyer-Dulheuer MD Legal Patentanwälte PartG mbB
(86) International application number: PCT/CN2020/088662
(87) International publication number: WO 2021/077712

(57) **Abstract**

The present disclosure relates to a bulk acoustic wave resonator. The resonator includes: a base, an acoustic lens, a bottom electrode, a top electrode, and a piezoelectric layer provided between the bottom electrode and the top electrode, wherein one of the bottom electrode and the top electrode is a first gap electrode; the first gap electrode is provided with a first electrode and a second electrode; the first electrode is in surface contact with the piezoelectric layer, the second electrode is away from the piezoelectric layer, and a gap layer is located between the first electrode and the second electrode in the thickness direction of the resonator; and the first electrode and the second electrode are electrically connected at an electrical connection portion, and the electrical connection portion defines at least part of a boundary of the gap layer. The resonator further includes an electrical isolation portion, wherein the projection of the electrical connection portion in the thickness direction of the resonator falls within the electrical isolation portion, and the inner side of the electrical isolation portion is used for defining a boundary of an active region of the resonator in the transverse direction of the resonator. The present disclosure further relates to a filter having the resonator and an electronic device having the filter or the resonator.

## Description

### TECHNICAL FIELD

Embodiments of the present disclosure relate to the field of semiconductors, and in particular, to a bulk acoustic wave resonator, a filter having the resonator, and an electronic device having the resonator or filter.

### BACKGROUND

Electronic components have been widely used as basic elements of electronic devices, applications of which include mobile phones, vehicles, household appliances and etc. In addition, technologies such as artificial intelligence, Internet of Things and 5G communications that will change the world in the future still need to rely on the electronic components.

The electronic components can exert different characteristics and advantages according to different working principles. Among all electronic components, components that use a piezoelectric effect (or an inverse piezoelectric effect) for working are an important type of electronic components. Piezoelectric devices have very wide applications. A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size, high resonant frequency, high quality factor, large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect.

The rapid development of communication technologies requires a continuous increase in the working frequency of a filter. For example, the frequency of a 5G communication frequency band (sub-6G) is between 3 GHz and 6 GHz, which is higher than that of 4G and other communication technologies. As for the bulk acoustic wave resonator and the filter, the high working frequency means that the film thickness, especially the film thickness of an electrode, needs to be further reduced. However, a main negative effect caused by the decrease in the film thickness of the electrode is a decrease in a Q value of the resonator resulting from an increase in the electrical loss, especially a decrease in the Q value at a series resonance point and its nearby frequencies. Correspondingly, the performance of a bulk acoustic wave filter with a high working frequency is greatly deteriorated with the decrease in the Q value of the bulk acoustic wave resonator.

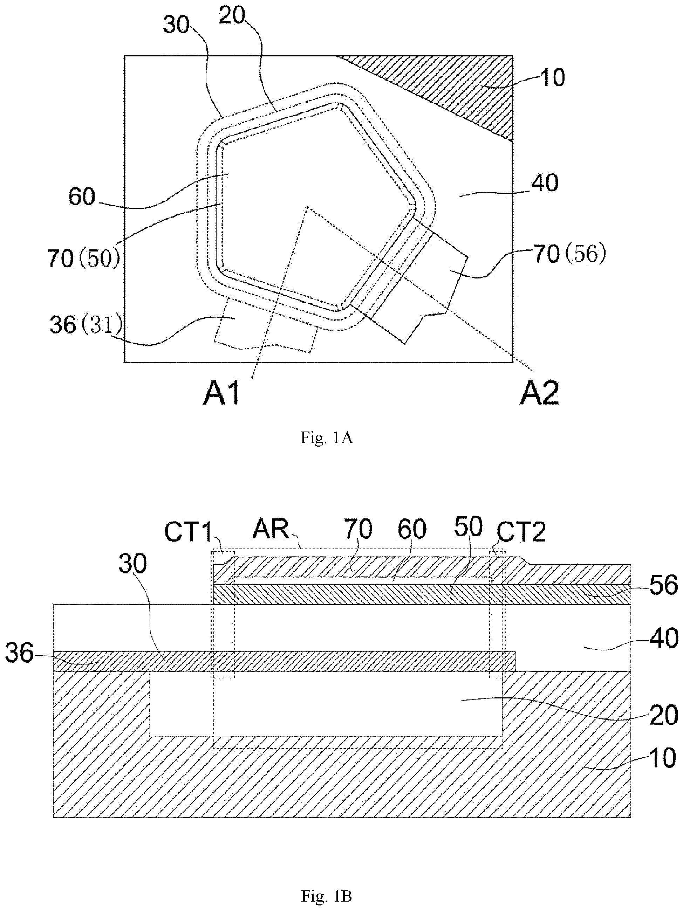

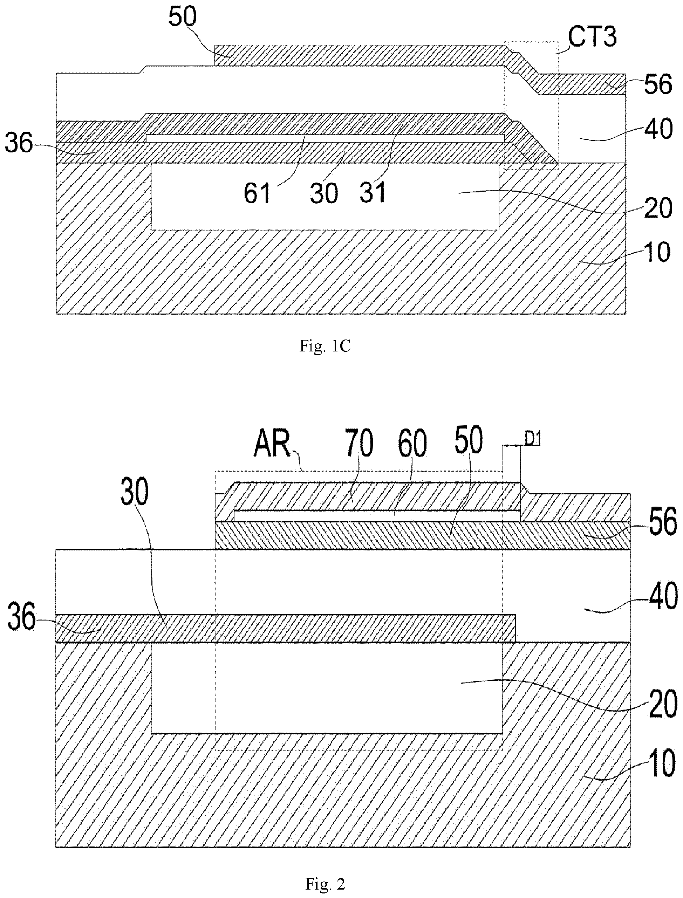

Fig. 1A is a schematic top view of a bulk acoustic wave resonator. Fig. 1B is a schematic sectional view along A1-A2 in Fig. 1A, in which an air gap is provided in a top electrode. Fig. 1C is a schematic sectional view of an additional structure along A1-A2 in Fig. 1A, in which a bottom electrode is provided with an air gap.

As shown in Fig. 1B, the resonator includes a substrate 10, an acoustic lens 20, a bottom electrode 30, a piezoelectric layer 40, a first top electrode 50, and a second top electrode 70. An air gap 60 is formed in the top electrode, the top electrode has an electrode pin 56, and the bottom electrode has an electrode pin 36.

As shown in Fig. 1C, the resonator includes a substrate 10, an acoustic lens 20, a first bottom electrode 30, a second bottom electrode 31, a piezoelectric layer 40, and a top electrode 50. An air gap 60 is formed in the bottom electrode, the top electrode has an electrode pin 56, and the bottom electrode has an electrode pin 36.

When the resonator with the structure shown in Figs. 1B and 1C is in operation, an alternating electric field is applied to the piezoelectric layer 40 through the electrodes. Due to the coupling and mutual conversion of acoustic and electrical energy, current flows through the electrodes. Since the top electrode has a double-layer electrode parallel structure, the electrical loss of the resonator is effectively reduced. Under the excitation of the alternating electric field, the piezoelectric layer generates acoustic waves. When the acoustic waves are conducted upwardly to an interface between the air gap 60 in the top electrode and the first top electrode 50, the energy of the acoustic waves will be reflected back to the piezoelectric layer 40 due to a great acoustic impedance mismatching degree between the air and the electrodes, and will not enter the second top electrode 70. Therefore, in Fig. 1, on one hand, the electrode structure containing the air gap can significantly reduce the electrical loss of the resonator, i.e. increases a Q value at and near a series resonant frequency. On the other hand, the air gap provides an acoustic isolation function on the top electrode 70, thereby substantially avoiding negative effects, such as changes in the resonant frequency and an electromechanical coupling coefficient, of the electrode layer 70 on the performance of the resonator.

As shown in Fig. 1B, the first top electrode 50 and the second top electrode 70 have contact portions CT1 and CT2 in an active region (AR). When the resonator is in operation, the contact portions CT1, CT2 and the bottom electrode 30 form a parasitic sandwich structure through the piezoelectric layer 40.

As shown in Fig. 1C, the first bottom electrode and the second bottom electrode form a parasitic sandwich structure with the piezoelectric layer and the top electrode outside the active region, as shown by CT3 in Fig. 1C.

### SUMMARY

The present disclosure is provided to alleviate or solve the above parasitic sandwich structure.

According to one aspect of embodiments of the present disclosure, a bulk acoustic wave resonator is provided and includes a substrate, an acoustic lens, a bottom electrode, a top electrode, and a piezoelectric layer provided between the bottom electrode and the top electrode. One of the bottom electrode and the top electrode is a first gap electrode, and the first gap electrode includes a first electrode and a second electrode. The first electrode is arranged in surface contact with the piezoelectric layer, and the second electrode is arranged away from the piezoelectric layer. The resonator further includes a gap layer provided between the first electrode and the second electrode in a thickness direction of the resonator. The first electrode and the second electrode are electrically connected to each other at an electrical connection portion, and the electrical connection portion defines at least part of a boundary of the gap layer. The resonator further includes an electrical isolation portion, and the electrical isolation portion has an inner side configured to define a boundary of an active region of the resonator in a transverse direction of the resonator. The electrical connection portion is located outside the active region in the transverse direction of the resonator, or a projection of the electrical connection portion in the thickness direction of the resonator falls within the electrical isolation portion.

The embodiments of the present disclosure also relate to a filter including the above bulk acoustic wave resonator.

The embodiments of the present disclosure also relate to an electronic device including the above filter or the above resonator.

### BRIEF DESCRIPTION OF DRAWINGS

The following description and drawings can help understand these and other features and advantages in various embodiments of the present disclosure. The same reference signs in the drawings always indicate the same components.
Fig. 1A is a schematic top view of a bulk acoustic wave resonator.
Fig. 1B is a schematic sectional view along A1-A2 in Fig. 1A, in which an air gap is formed in a top electrode.
Fig. 1C is a schematic sectional view of an additional structure along A1-A2 in Fig. 1A, in which an air gap is formed in a bottom electrode.
Fig. 2 is a schematic sectional view similar to that along A1-A2 in Fig. 1A according to an exemplary embodiment of the present disclosure, in which a top electrode is provided with a gap layer.

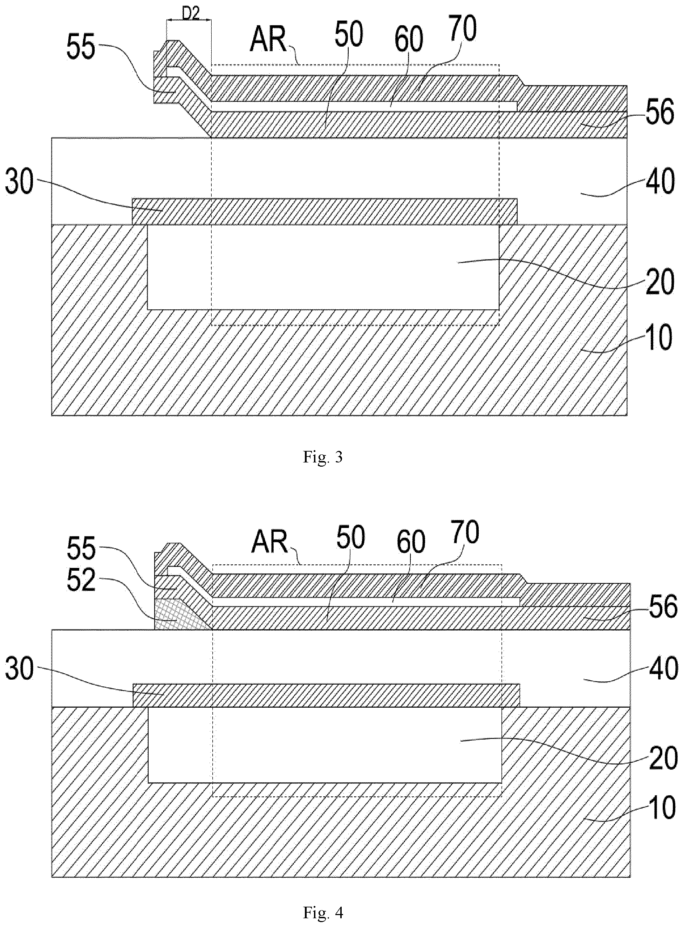

Fig. 3 is a schematic sectional view similar to that along A1-A2 in Fig. 1A according to another exemplary embodiment of the present disclosure, in which a top electrode is provided with a gap layer and a wing structure.
Fig. 4 is a schematic sectional view similar to that along A1-A2 in Fig. 1A according to yet another exemplary embodiment of the present disclosure, in which a top electrode is provided with a gap layer and a wing structure.

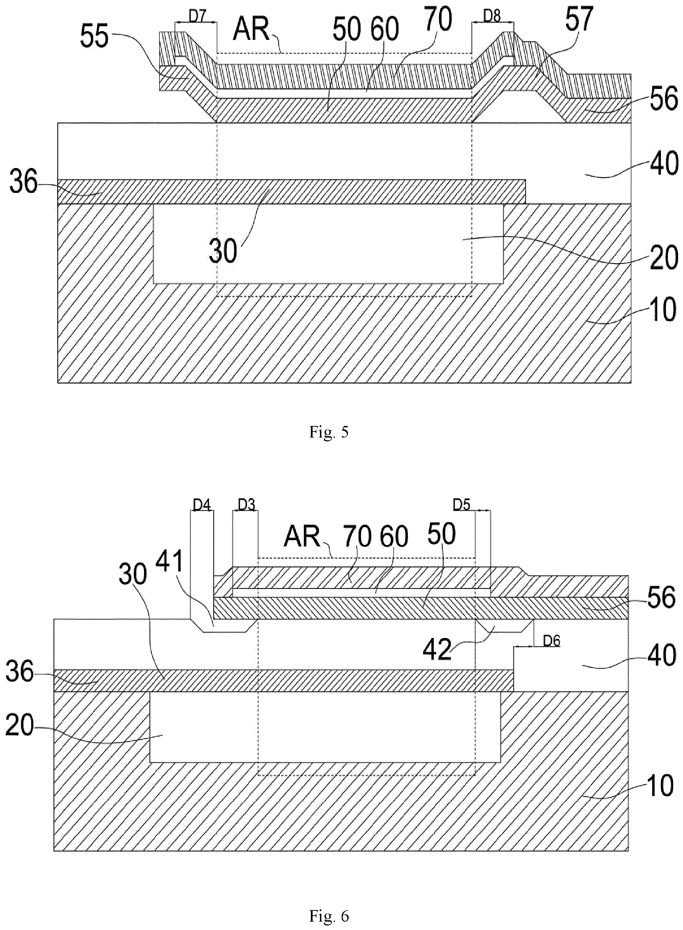

Fig. 5 is a schematic sectional view similar to that along A1-A2 in Fig. 1A according to yet another exemplary embodiment of the present disclosure, in which a top electrode is provided with a gap layer, a wing structure, and a bridge structure.
Fig. 6 is a schematic sectional view similar to that along A1-A2 in Fig. 1A according to still another exemplary embodiment of the present disclosure, in which a top electrode is provided with a gap layer, and an upper surface of a piezoelectric layer is provided with a recess portion as an electrical isolation portion.

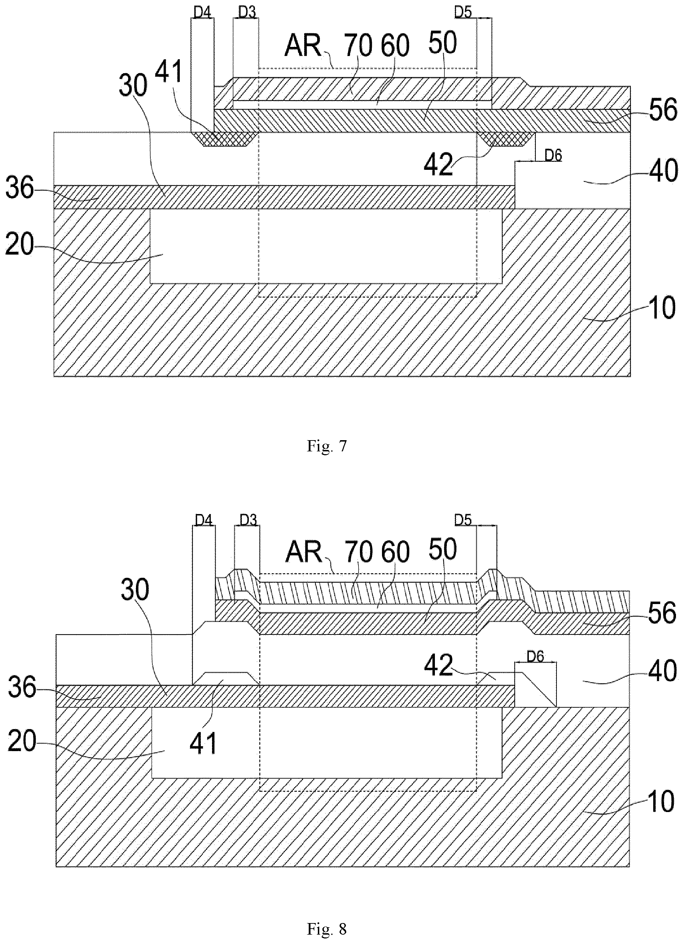

Fig. 7 is a schematic sectional view similar to that along A1-A2 in Fig. 1A according to still another exemplary embodiment of the present disclosure, in which a top electrode is provided with a gap layer, and an upper surface of a piezoelectric layer is provided with a recess portion as an electrical isolation portion.
Fig. 8 is a schematic sectional view similar to that along A1-A2 in Fig. 1A according to still another exemplary embodiment of the present disclosure, in which a top electrode is provided with a gap layer, and a lower surface of a piezoelectric layer is provided with a recess portion as an electrical isolation portion.

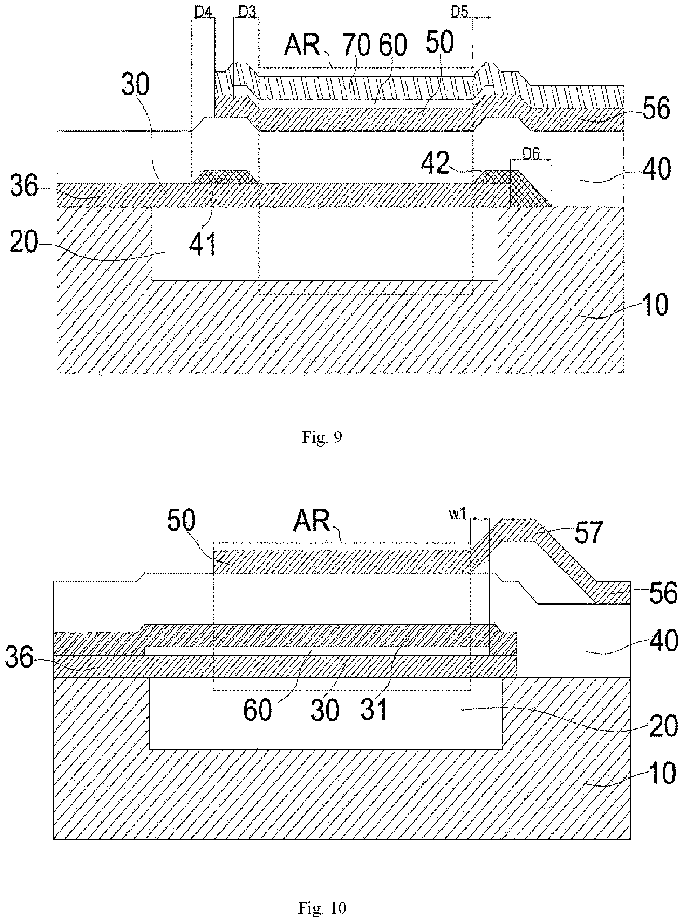

Fig. 9 is a schematic sectional view similar to that along A1-A2 in Fig. 1A according to still another exemplary embodiment of the present disclosure, in which a top electrode is provided with a gap layer, and a lower surface of a piezoelectric layer is provided with a recess portion as an electrical isolation portion.
Fig. 10 is a schematic sectional view similar to that along A1-A2 in Fig. 1A according to an exemplary embodiment of the present disclosure, in which a bottom electrode is provided with a gap layer, and a top electrode is provided with a bridge structure.

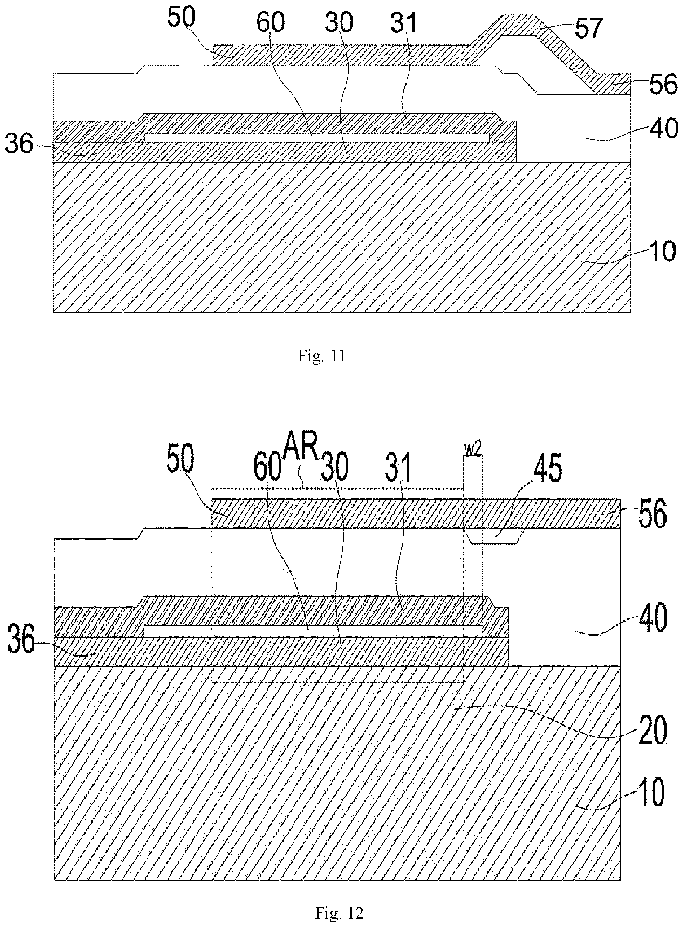

Fig. 11 is a schematic sectional view similar to that along A1-A2 in Fig. 1A according to another exemplary embodiment of the present disclosure, in which a bottom electrode is provided with a gap layer, a top electrode is provided with a bridge structure, and the gap layer forms an acoustic lens.
Fig. 12 is a schematic sectional view similar to that along A1-A2 in Fig. 1A according to another exemplary embodiment of the present disclosure, in which a bottom electrode is provided with a gap layer, an upper surface of a piezoelectric layer is provided with a recess portion as an electrical isolation portion, and the gap layer forms an acoustic lens.

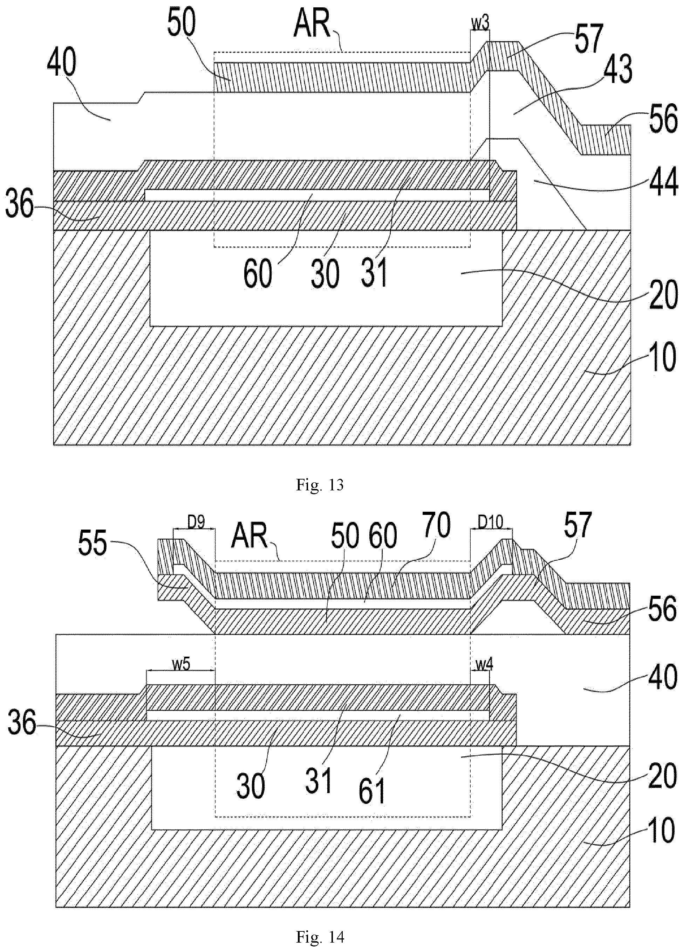

Fig. 13 is a schematic sectional view similar to that along A1-A2 in Fig. 1A according to another exemplary embodiment of the present disclosure, in which a bottom electrode is provided with a gap layer, and a space that is used as an electrical isolation portion is provided between a lower surface of a piezoelectric layer and a non-pin end of the bottom electrode.
Fig. 14 is a schematic sectional view similar to that along A1-A2 in Fig. 1A according to another exemplary embodiment of the present disclosure, in which a bottom electrode and a top electrode are both provided with gap layers, and the top electrode is further provided with a wing structure and a bridge structure.

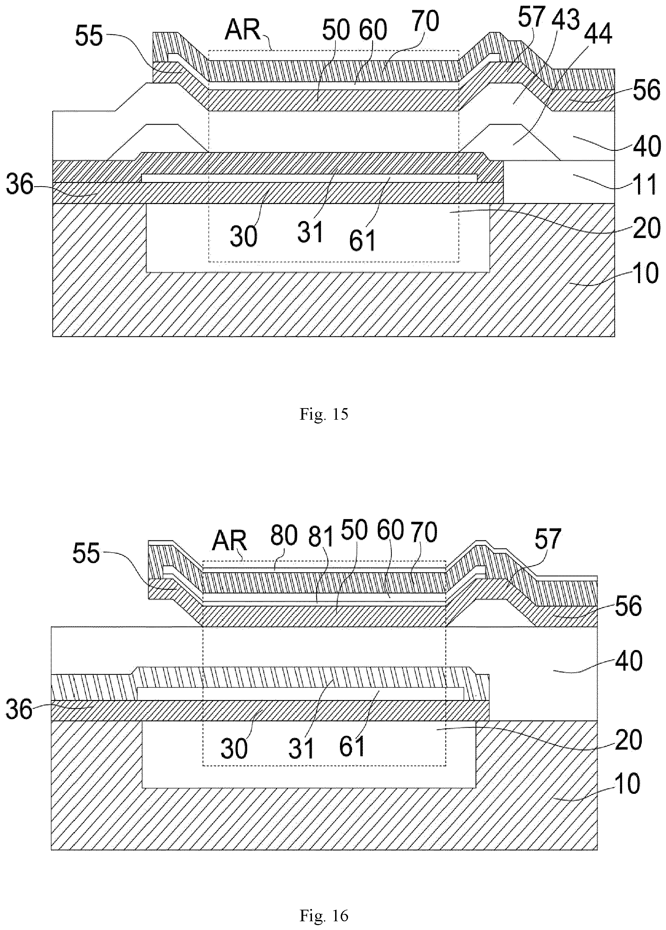

Fig. 15 is a schematic sectional view similar to that along A1-A2 in Fig. 1A according to another exemplary embodiment of the present disclosure, in which a bottom electrode and a top electrode are both provided with gap layers, a space that is used as an electrical isolation portion is formed between a lower surface of a piezoelectric layer and a pin end of the bottom electrode, and a space that is used as an electrical isolation portion is formed between the lower surface of the piezoelectric layer and a non-pin end of the bottom electrode.
Fig. 16 is a schematic sectional view similar to that along A1-A2 in Fig. 1A according to another exemplary embodiment of the present disclosure, in which a bottom electrode and a top electrode are both provided with gap layers, the top electrode is further provided with a wing structure and a bridge structure, and upper surfaces of a first top electrode and a second top electrode are both provided with passivation layers.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as limitation to the present disclosure.

In Figs. 2-16, the reference signs are described as follows:
10: a substrate, which is made of silicon (high-resistance silicon), gallium arsenide, sapphire, quartz or the like;
20: an acoustic lens, which may be a cavity 20, or may employ a Bragg reflection layer or other equivalent forms, and may be formed by a gap layer in a bottom electrode;
30: a first bottom electrode, which may be made of molybdenum, ruthenium, gold, aluminum, magnesium, tungsten, copper, titanium, iridium, osmium or chromium, or a compound or an alloy thereof;
36: an electrode pin, a material of which is the same as that of the first bottom electrode;
31: a second bottom electrode, a material of which is selected from the same material range as that of the first bottom electrode 30, but the material may not be the same as that of the first bottom electrode 30;
40: a piezoelectric film layer, which may be made of aluminum nitride (AlN), zinc oxide (ZnO), lead zirconate titanate (PZT), lithium niobate (LiNbO₃), quartz, potassium niobate (KNbO₃), lithium tantalate (LiTaO₃) or the like, and may contain rare earth element doped materials with a certain atomic ratio of the above materials;
50: a first top electrode, which may be made of molybdenum, ruthenium, gold, aluminum, magnesium, tungsten, copper, titanium, iridium, osmium or chromium, or a compound or an alloy thereof;
56: an electrode pin, a material of which is the same as that of the first top electrode;
60: an air gap formed in the top electrode and arranged between the first top electrode 50 and a second top electrode 70; and
70: the second top electrode, a material of which is selected from the same material range as that of the first top electrode 50, but the material may not be the same as that of the first top electrode 50.

It should be noted that the air gap forms a gap layer. However, in the present disclosure, the gap layer may be a vacuum gap layer except for an air gap layer, or may be a gap layer filled with other gas medium.

Fig. 2 is a schematic sectional view alongA1-A2 in Fig. 1 according to an exemplary embodiment of the present disclosure, in which a top electrode is provided with a gap layer.

As shown in Fig. 2, a right end of the air gap extends beyond an active region (AR), and extends to an outer side of a non-pin end of the bottom electrode in a transverse direction, or the right end of the air gap may be flush with the outer side of the non-pin end of the bottom electrode, such that parasitism generated by an additional electrode 70 on a pin end may be eliminated. The right end of the air gap 60 extends beyond the AR by a distance D1, and D1 is in a range of 0 µm to 20 µm. In Fig. 2, an electrical connection portion between an electrode pin end of the first top electrode and an electrode pin end of the second top electrode is located outside the active region, and does not overlap with a projection of the bottom electrode in a thickness direction of the resonator. In this way, it is possible to prevent the electrical connection portion from forming a parasitic sandwich structure along with a piezoelectric layer and an additional electrode.

In addition, when the resonator is in operation, an alternating electric field is applied to the piezoelectric layer 40 through the electrodes. Due to the coupling and mutual conversion of acoustic and electrical energy, current flows through the electrodes. Since the top electrode of the present embodiment has a double-layer electrode parallel structure, the electrical loss of the resonator is effectively reduced. Under the excitation of the alternating electric field, the piezoelectric layer generates acoustic waves. When the acoustic waves are conducted upwardly to an interface between the air gap 60 in the top electrode and the top electrode 50, the energy of the acoustic waves will be reflected back to the piezoelectric layer 40 due to a great acoustic impedance mismatching degree between the air and the electrodes, and will not enter the top electrode 70. On one hand, the electrode structure containing the air gap in the present disclosure significantly reduces the electrical loss of the resonator, i.e. increases a Q value at and near a series resonant frequency. On the other hand, the air gap provides an acoustic isolation function on the top electrode 70, thereby substantially avoiding negative effects, such as changes in the resonant frequency and an electromechanical coupling coefficient, of the electrode 70 on the performance of the resonator.

The air gap has a height generally greater than a typical amplitude (about 10 nm) of the resonator. For example, the height of the air gap is in a range of 100 Å to 5000 Å, and further, in a range of 100 Å to 5000 Å. In this way, this is beneficial for decoupling the top electrode 70 from the acoustic energy of a resonator cavity when the resonator works at a high power. In the present embodiment, the resonator cavity is a composite structure formed by the top electrode 50, the piezoelectric layer 40, and the bottom electrode 30.

Fig. 3 is a schematic sectional view similar to that along A1-A2 in Fig. 1A according to another exemplary embodiment of the present disclosure, in which a top electrode is provided with a gap layer and a wing structure.

As shown in Fig. 3, a wing structure 55 may be formed on a non-pin end of a top electrode, and a left end of an air gap 60 extends along the surface of the wing structure 55 to outside of a boundary of an acoustic active region (AR). A transverse distance between an edge of a non-pin side of the air gap 60 and the boundary of the AR is D2, and D2 is in a range of 0 µm to 40 µm.

It should be noted herein that the left edge of the air gap 60 shown in Fig. 3 has extended to a horizontal portion of the wing structure 55, which is only an embodiment. In another embodiment, the left edge of the air gap 60 may extend to a location of an inclined portion of the wing structure 55. The above embodiments both fall within the scope of the present disclosure. Moreover, the description is applicable to subsequent bridge/wing structures.

In Fig. 3, an electrical connection portion between right sides of the first top electrode and the second top electrode is a first electrical connection portion, and an electrical connection portion between the right sides is a second electrical connection portion.

In Fig. 3, a space 52 formed between the wing structure and a surface of the piezoelectric layer is used as an electrical isolation portion. As shown in Fig. 3, a projection of the second electrical connection portion in the thickness direction of the resonator falls within the electrical isolation portion, and an inner side of the electrical isolation portion is used to define a boundary of the active region.

Fig. 4 is a schematic sectional view similar to that along A1-A2 in Fig. 1A according to yet another exemplary embodiment of the present disclosure, in which a top electrode is provided with a gap layer and a wing structure. Fig. 4 is different from Fig. 3 in that the space 52 located below the wing structure is filled with a dielectric material to achieve an effect of eliminating the parasitic structure. The filled substance may be silicon dioxide, silicon nitride, silicon carbide, and various metal oxides or non-piezoelectric materials such as epoxy resin.

Fig. 5 is a schematic sectional view similar to that along A1-A2 in Fig. 1A according to yet another exemplary embodiment of the present disclosure, in which a top electrode is provided with a gap layer, a wing structure, and a bridge structure. The structure of Fig. 5 includes a bridge structure 57 formed on a pin side of the top electrode on the basis of the structure of Fig. 3. In this way, the electrode of the bridge portion is separated from the piezoelectric layer such that the AR is retracted into the air gap 60 in a transverse direction. Accordingly, the edge of the pin side of the air gap 60 extends along the bridge structure to the outside of the boundary of the AR, thereby eliminating the parasitic structure. A transverse distance between the AR and a left side edge of the air gap 60 is D7, and a transverse distance between the AR and a right side edge of the air gap 60 is D8. D7 and D8 are both in a range of 0 µm to 40 µm.

Fig. 6 is a schematic sectional view similar to that along A1-A2 in Fig. 1A according to still another exemplary embodiment of the present disclosure, in which a top electrode is provided with a gap layer, and an upper surface of a piezoelectric layer is provided with a recess portion as an electrical isolation portion.

In addition to forming a wing/bridge structure on the electrode 50, air recesses (recess portions) 41 and 42 are formed on the upper surface of the piezoelectric layer 40 and arranged below a contact portion of the top electrodes 50 and 70 as the structure shown in Fig. 6. Accordingly, the electrode 50 is separated from the piezoelectric layer 40, thereby eliminating a parasitic effect. An edge of an air gap 60 extends beyond the boundary of the active region (AR). A transverse distance between an edge of a non-pin side of the air gap 60 and the boundary of the AR is D3, a transverse distance between an edge of a pin side of the air gap 60 and the boundary of the AR is D5, and D3 and D5 are in a range of 0 µm to 40 µm. In addition, a left side boundary of the non-pin side recess 41 of the top electrode is located outside the edge of the non-pin side of the top electrode, and a distance D4 between the two portions is in a range of 0 µm to 40 µm. A left side boundary of the pin side recess 42 of the top electrode is located outside the edge of the non-pin side of the bottom electrode, and a distance D6 between the two portions is in a range of 0 µm to 40 µm.

Fig. 7 is a schematic sectional view similar to that along A1-A2 in Fig. 1A according to still another exemplary embodiment of the present disclosure, in which a top electrode is provided with a gap layer, and an upper surface of a piezoelectric layer is provided with a recess portion as an electrical isolation portion. As shown in Fig. 7, the recesses 41, 42 of the structure in Fig. 6 are filled with a dielectric material, which may be selected a material with reference to the filling material of the space 52 in Fig. 4.

Fig. 8 is a schematic sectional view similar to that along A1-A2 in Fig. 1A according to still another exemplary embodiment of the present disclosure, in which a top electrode is provided with a gap layer, and a lower surface of a piezoelectric layer is provided with a recess portion as an electrical isolation portion. As shown in Fig. 8, the air recesses 41 and 42 may be formed on the lower surface of the piezoelectric layer 40 to achieve the effect of eliminating the parasitic effect. Based on some processes, when a structure with recesses that are formed on the lower surface of the piezoelectric layer 40 is manufactured, structural undulations as shown in Fig. 8 may be formed.

The air recesses 41, 42 in Fig. 8 may be filled with a non-piezoelectric dielectric material, which may be selected with reference to the filling material of the space 52 in Fig. 4, as shown in Fig. 9. Fig. 9 is a schematic sectional view similar to that along A1-A2 in Fig. 1A according to still another exemplary embodiment of the present disclosure, in which a top electrode is provided with a gap layer, and a lower surface of a piezoelectric layer is provided with a recess portion as an electrical isolation portion.

The parasitic structure in Fig. 1C may be eliminated by using the structure in Fig. 10. Fig. 10 is a schematic sectional view similar to that along A1-A2 in Fig. 1A according to an exemplary embodiment of the present disclosure, in which a bottom electrode is provided with a gap layer and a top electrode is provided with a bridge structure. In the structure of the resonator shown in Fig. 10, the pin side of the electrode 50 has an arched shape to form a bridge structure 57, and the bridge portion of the electrode is separated from the piezoelectric layer 40 located below the bridge portion, thereby eliminating the parasitic sandwich structure formed by the piezoelectric layer of the top electrode and the bottom electrodes 31 and 30 in Fig. 1C. In Fig. 10, an edge of the air gap 60 located on the non-pin side of the bottom electrode extends beyond a newly formed active region (AR), and a distance w1 therebetween is in a range of 0 µm to 40 µm.

Fig. 11 is a schematic sectional view similar to that along A1-A2 in Fig. 1A according to another exemplary embodiment of the present disclosure, in which a bottom electrode is provided with a gap layer, a top electrode is provided with a bridge structure, and the gap layer forms an acoustic lens.

Fig. 12 is a schematic sectional view similar to that along A1-A2 in Fig. 1A according to another exemplary embodiment of the present disclosure, in which a bottom electrode is provided with a gap layer, an upper surface of a piezoelectric layer is provided with a recess portion as an electrical isolation portion, and the gap layer forms an acoustic lens. The parasitic effect can be eliminated by arching the pin side of the top electrode 50 to form an arched structure. Further, as shown in Fig. 12, the parasitic sandwich structure in Fig. 1C can be eliminated by forming an air recess 45 on the upper surface of the piezoelectric layer 40. A transverse distance between the air gap and the boundary of the AR is w2, and w2 is in a range of 0 µm to 40 µm.

Fig. 13 is a schematic sectional view similar to that along A1-A2 in Fig. 1A according to another exemplary embodiment of the present disclosure, in which a bottom electrode is provided with a gap layer, and a space is formed between a lower surface of a piezoelectric layer and a non-pin end of the bottom electrode to be used as an electrical isolation portion. A recess portion 44 may be formed on the lower surface of the piezoelectric layer 40 as shown in Fig. 13. In Fig. 13, a transverse distance between the air gap and the boundary of the AR is w3, and w3 is in a range of 0 µm to 40 µm.

Fig. 14 is a schematic sectional view similar to that along A1-A2 in Fig. 1A according to another exemplary embodiment of the present disclosure, in which a bottom electrode and a top electrode are both provided with gap layers, and the top electrode is further provided with a wing structure and a bridge structure. The top electrode and the bottom electrode of the resonator in Fig. 14 have air gaps 60 and 61, respectively. Edges of the air gaps 60 and 61 both extend beyond the active region (AR). A transverse distance between a non-pin side edge of the air gap 60 and the boundary of the AR is D9. A transverse distance between a pin side edge of the air gap 60 and the boundary of the AR is D10. A transverse distance between a pin side edge of the air gap 61 and the boundary of the AR is w5. A transverse distance between a non-pin side edge of the air gap 61 and the boundary of the AR is w3. In Fig. 14, D9, D10, w3 and w5 are in a range of 0 µm to 40 µm.

Fig. 15 is a schematic sectional view similar to that along A1-A2 in Fig. 1A according to another exemplary embodiment of the present disclosure, in which a bottom electrode and a top electrode are both provided with gap layers, a space that is used as an electrical isolation portion is formed between a lower surface of a piezoelectric layer and a pin end of the bottom electrode, and a space that is used as an electrical isolation portion is formed between the lower surface of the piezoelectric layer and a non-pin end of the bottom electrode. In Fig. 15, a recess portion 44 is formed on the lower surface of the piezoelectric layer, thereby eliminating the parasitic sandwich structure. A distance between the air gap and the boundary of the AR is the same as that in Fig. 14.

Fig. 16 is a schematic sectional view similar to that along A1-A2 in Fig. 1A according to another exemplary embodiment of the present disclosure, in which a bottom electrode and a top electrode are both provided with gap layers, the top electrode is further provided with a wing structure and a bridge structure, and upper surfaces of a first top electrode and a second top electrode are both provided with passivation layers. The upper surface of the first top electrode 50 and the upper surface of the second top electrode 70 are respectively covered with passivation layers 81 and 80 to prevent metal oxidation.

In the present disclosure, the gap layer is formed in the top electrode and/or bottom electrode of the bulk acoustic wave resonator. The air gap of the electrode effectively reflects acoustic waves, thereby greatly reducing the energy of the acoustic waves entering the additional electrode on a side away from a piezoelectric film or the piezoelectric layer, thus effectively suppressing or eliminating negative effects of the additional electrode caused by participating in acoustic vibration.

In addition, when two layers (a plurality of layers) of electrodes enclosing the air gap form a parallel circuit structure, it is possible to effectively reduce the electrical loss of the resonator, and improve the Q value of the resonator, especially the Q value at the series resonance point and its nearby frequencies.

Therefore, the additional electrode is acoustically decoupled from the resonant cavity of the resonator due to the presence of the air gap since most of acoustic waves are reflected back to the resonant cavity at the air gap and do not enter the additional electrode. Other key parameters (such as the resonant frequency and the electromechanical coupling coefficient) other than the Q value of the resonator are not affected by the additional electrode and parameter changes.

Compared with a structure in which the air gap is located between the piezoelectric layer and the electrode, the present disclosure has the advantages that since parasitic series capacitance caused by the air gap is avoided, the electromechanical coupling coefficient kt² of the resonator will not deteriorate. Compared with a structure in which a temperature compensation interlayer (e.g., silicon dioxide) is located between two layers of electrodes, the air gap or vacuum gap of the present disclosure maintains the resonant frequency of the resonator unchanged. In this way, other key parameters (such as, the Q value and the electromechanical coupling coefficient) will not deteriorate, and the Q value at the series resonance point and its nearby frequencies is increased on the contrary.

In the present disclosure, when the acoustic lens structure is provided in the substrate and no gap layer is provided in the bottom electrode, an effective region of the resonator is an overlapping region of the top electrode, the piezoelectric layer, the bottom electrode, and the acoustic lens in the thickness direction of the resonator.

In the present disclosure, when the gap layer is provided in the bottom electrode, the effective region of the resonator is an overlapping region of the top electrode, the bottom electrode, the piezoelectric layer, and the gap layer of the bottom electrode in the thickness direction of the resonator. When the gap layer is formed in the bottom electrode, a gap layer may be formed in the top electrode or not at the same time.

In the present disclosure, a mentioned numerical range may not only be endpoint values, but may also be a mean value of the endpoint values or other values, which are all within the protection scope of the present disclosure.

In the present disclosure, an "inner side" and "outer side" of a component are determined by which part of the component is closer to a center of the active region of the resonator in the transverse direction of the resonator. If a side is close to the center of the active region of the resonator, it is the inner side. Instead, if a side is far away from the center of the active region of the resonator, it is the outer side.

As can be appreciated by those skilled in the art, the bulk acoustic wave resonator according to the present disclosure can be used to form a filter.

Based on the above description and in conjunction with the drawings of the present disclosure, the present disclosure provides the following technical solutions.
1. A bulk acoustic wave resonator includes:
   a substrate;
   an acoustic lens;
   a bottom electrode;
   a top electrode; and
   a piezoelectric layer provided between the bottom electrode and the top electrode, wherein
   one of the bottom electrode and the top electrode is a first gap electrode, the first gap electrode includes a first electrode and a second electrode, the first electrode is arranged in surface contact with the piezoelectric layer, and the second electrode is arranged away from the piezoelectric layer;
   the resonator further includes a gap layer provided between the first electrode and the second electrode in a thickness direction of the resonator, the first electrode and the second electrode are electrically connected to each other at an electrical connection portion, and the electrical connection portion is configured to define at least part of a boundary of the gap layer;
   the resonator further includes an electrical isolation portion, and the electrical isolation portion has an inner side that is configured to define a boundary of an active region of the resonator in a transverse direction of the resonator; and
   the electrical connection portion is arranged outside the active region in the transverse direction of the resonator, or a projection of the electrical connection portion in the thickness direction of the resonator falls within the electrical isolation portion.
2. The resonator according to 1, wherein
   the first gap electrode is the top electrode; and
   the electrical connection portion includes a first electrical connection portion that is provided on a pin end of the first gap electrode and located outside the active region, and the first electrical connection portion is located on an outer side of a non-pin end of the bottom electrode in the transverse direction of the resonator.
3. The resonator according to 1, wherein
   the first gap electrode is the top electrode, and the first electrode of the first gap electrode has a non-pin end that is provided with a wing structure;
   the electrical connection portion includes a second electrical connection portion that is provided on the non-pin end of the first gap electrode and located outside the active region, and the second electrical connection portion is located on the wing structure; and
   the electrical isolation portion includes an electrical isolation portion formed by a space provided between the wing structure and the piezoelectric layer.
4. The resonator according to 2, wherein
   the first gap electrode is the top electrode, and the first electrode of the first gap electrode has a non-pin end that is provided with a wing structure;
   the electrical connection portion includes a second electrical connection portion that is provided on the non-pin end of the first gap electrode and located inside a first active region, and the second electrical connection portion is located on the wing structure; and
   the electrical isolation portion includes an electrical isolation portion formed by a space provided between the wing structure and the piezoelectric layer.
5. The resonator according to 1, wherein
   the electrical isolation portion is filled with a dielectric material.
6. The resonator according to 1 or 3, wherein
   the first gap electrode is the top electrode, and the first electrode of the first gap electrode is provided with a bridge structure on a pin end thereof;
   the electrical connection portion includes a first electrical connection portion that is provided on the pin end of the first gap electrode and located outside the active region, and the first electrical connection portion is partially located on the bridge structure;
   the electrical isolation portion includes an electrical isolation portion formed by a space provided between the bridge structure and the piezoelectric layer; and
   in the thickness direction of the resonator, the non-pin end of the bottom electrode that is located in a projection of the pin end of the first gap electrode falls within a projection of the bridge structure.
7. The resonator according to 1, wherein
   the electrical isolation portion includes at least one recess portion provided in the piezoelectric layer, and the at least one recess portion has an inner side configured to define the boundary of the active region.
8. The resonator according to 7, wherein
   the at least one recess portion is filled with a dielectric material.
9. The resonator according to 7, wherein the electrical connection portion includes:
   a first electrical connection portion provided on a pin end of the first gap electrode and located outside the active region; and
   a second electrical connection portion provided on a non-pin end of the first gap electrode and located outside the active region.
10. The resonator according to 9, wherein
   the at least one recess portion has an outer side, which is located on an outer side of the second electrical connection portion in the transverse direction of the resonator; or
   the at least one recess portion has an outer side, which is flush with an outer side of the second electrical connection portion in the thickness direction of the resonator.
11. The resonator according to 10, wherein
   the first gap electrode is the top electrode; and
   in the thickness direction of the resonator, the bottom electrode has a non-pin end, of which a projection is located within a projection of a pin end of the top electrode and falls within a projection of a corresponding one of the at least one recess portion.
12. The resonator according to 7, wherein
   the at least one recess portion is provided on an upper surface of the piezoelectric layer; or
   the at least one recess portion is provided on a lower surface of the piezoelectric layer.
13. The resonator according to 1, wherein
   the first gap electrode is the bottom electrode, and the top electrode is provided with a bridge structure on a pin end thereof;
   the electrical connection portion includes a first electrical connection portion provided on a non-pin end of the first gap electrode, and the first electrical connection portion is located within a projection of the top electrode; and
   the electrical isolation portion includes an electrical isolation portion formed by a space provided between the bridge structure and the piezoelectric layer.
14. The resonator according to 13, wherein
   the gap layer forms the acoustic lens.
15. The resonator according to 1, wherein
   the first gap electrode is the bottom electrode, the electrical connection portion includes a first electrical connection portion provided on a non-pin end of the first gap electrode, and the first electrical connection portion is located within a projection of the top electrode; and
   the electrical isolation portion includes an electrical isolation portion formed, at a location adjacent to the first electrical connection portion, by a space provided between a lower surface of the piezoelectric layer and the first electrical connection portion, or the electrical isolation portion includes an electrical isolation portion formed, at a location adjacent to the first electrical connection portion, by a space enclosed with a lower surface of the piezoelectric layer, the first electrical connection portion, and an upper surface of the substrate.
16. The resonator according to 1, wherein
   another one of the top electrode and the bottom electrode is a second gap electrode;
   the second gap electrode includes a third electrode and a fourth electrode, the third electrode is arranged in surface contact with the piezoelectric layer, and the fourth electrode is arranged away from the piezoelectric layer; and
   the resonator further includes an additional gap layer provided between the third electrode and the fourth electrode in the thickness direction of the resonator, the third electrode and the fourth electrode are electrically connected to each other at an additional electrical connection portion, the additional electrical connection portion defines at least part of a boundary of the additional gap layer, and the additional electrical connection portion is located outside the active region in the transverse direction of the resonator.
17. The resonator according to any one of 1-16, wherein
   the gap layer is an air gap layer or a vacuum gap layer.
18. The resonator according to any one of 1-16, wherein
   the gap layer has a thickness in a range of 50 Å to 10000 Å.
19. The resonator according to 18, wherein
   the thickness of the gap layer is in a range of 100 Å to 5000 Å.
20. A filter includes the bulk acoustic wave resonator according to any one of 1-19.
21. An electronic device includes the filter according to 20 or the resonator according to any one of 1-19.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic lens;
a bottom electrode;
a top electrode; and
a piezoelectric layer provided between the bottom electrode and the top electrode,
wherein one of the bottom electrode and the top electrode is a first gap electrode, the first gap electrode comprises a first electrode and a second electrode, the first electrode is arranged in surface contact with the piezoelectric layer, and the second electrode is arranged away from the piezoelectric layer;
wherein the resonator further includes a gap layer provided between the first electrode and the second electrode in a thickness direction of the resonator, the first electrode and the second electrode are electrically connected to each other at an electrical connection portion, and the electrical connection portion defines at least part of a boundary of the gap layer;
wherein the resonator further includes an electrical isolation portion, and the electrical isolation portion has an inner side that is configured to define a boundary of an active region of the resonator in a transverse direction of the resonator; and
wherein the electrical connection portion is arranged outside the active region in the transverse direction of the resonator, or a projection of the electrical connection portion in the thickness direction of the resonator falls within the electrical isolation portion.

2. The resonator according to claim 1, wherein the first gap electrode is the top electrode; and
the electrical connection portion comprises a first electrical connection portion that is provided on a pin end of the first gap electrode and located outside the active region, and the first electrical connection portion is located on an outer side of a non-pin end of the bottom electrode in the transverse direction of the resonator.

3. The resonator according to claim 1, wherein the first gap electrode is the top electrode, and the first electrode of the first gap electrode has a non-pin end that is provided with a wing structure;
the electrical connection portion comprises a second electrical connection portion that is provided on the non-pin end of the first gap electrode and located outside the active region, and the second electrical connection portion is located on the wing structure; and
the electrical isolation portion comprises an electrical isolation portion formed by a space provided between the wing structure and the piezoelectric layer.

4. The resonator according to claim 2, wherein the first gap electrode is the top electrode, and the first electrode of the first gap electrode has a non-pin end that is provided with a wing structure;
the electrical connection portion comprises a second electrical connection portion that is provided on the non-pin end of the first gap electrode and located inside a first active region, and the second electrical connection portion is located on the wing structure; and
the electrical isolation portion comprises an electrical isolation portion formed by a space provided between the wing structure and the piezoelectric layer.

5. The resonator according to claim 1, wherein the electrical isolation portion is filled with a dielectric material.

6. The resonator according to claim 1 or 3, wherein the first gap electrode is the top electrode, and the first electrode of the first gap electrode is provided with a bridge structure on a pin end thereof;
the electrical connection portion comprises a first electrical connection portion that is provided on the pin end of the first gap electrode and located outside the active region, and the first electrical connection portion is partially located on the bridge structure;
the electrical isolation portion comprises an electrical isolation portion formed by a space provided between the bridge structure and the piezoelectric layer; and
in the thickness direction of the resonator, the non-pin end of the bottom electrode that is located in a projection of the pin end of the first gap electrode falls within a projection of the bridge structure.

7. The resonator according to claim 1, wherein the electrical isolation portion comprises at least one recess portion provided in the piezoelectric layer, and the at least one recess portion has an inner side configured to define the boundary of the active region.

8. The resonator according to claim 7, wherein the at least one recess portion is filled with a dielectric material.

9. The resonator according to claim 7, wherein the electrical connection portion comprises:
a first electrical connection portion provided on a pin end of the first gap electrode and located outside the active region; and
a second electrical connection portion provided on a non-pin end of the first gap electrode and located outside the active region.

10. The resonator according to claim 9, wherein the at least one recess portion has an outer side, which is located on an outer side of the second electrical connection portion in the transverse direction of the resonator; or
the at least one recess portion has an outer side, which is flush with an outer side of the second electrical connection portion in the thickness direction of the resonator.

11. The resonator according to claim 10, wherein the first gap electrode is the top electrode; and
in the thickness direction of the resonator, the bottom electrode has a non-pin end, of which a projection is located within a projection of a pin end of the top electrode and falls within a projection of a corresponding one of the at least one recess portion.

12. The resonator according to claim 7, wherein the at least one recess portion is provided on an upper surface of the piezoelectric layer; or
the at least one recess portion is provided on a lower surface of the piezoelectric layer.

13. The resonator according to claim 1, wherein the first gap electrode is the bottom electrode, and the top electrode is provided with a bridge structure on a pin end thereof;
the electrical connection portion comprises a first electrical connection portion provided on a non-pin end of the first gap electrode, and the first electrical connection portion is located within a projection of the top electrode; and
the electrical isolation portion comprises an electrical isolation portion formed by a space provided between the bridge structure and the piezoelectric layer.

14. The resonator according to claim 13, wherein the gap layer forms the acoustic lens.

15. The resonator according to claim 1, wherein the first gap electrode is the bottom electrode, the electrical connection portion comprises a first electrical connection portion provided on a non-pin end of the first gap electrode, and the first electrical connection portion is located within a projection of the top electrode; and
the electrical isolation portion comprises an electrical isolation portion formed, at a location adjacent to the first electrical connection portion, by a space provided between a lower surface of the piezoelectric layer and the first electrical connection portion, or the electrical isolation portion comprises an electrical isolation portion formed, at a location adjacent to the first electrical connection portion, by a space enclosed with a lower surface of the piezoelectric layer, the first electrical connection portion, and an upper surface of the substrate.

16. The resonator according to claim 1, wherein another one of the top electrode and the bottom electrode is a second gap electrode;
the second gap electrode comprises a third electrode and a fourth electrode, the third electrode is arranged in surface contact with the piezoelectric layer, and the fourth electrode is arranged away from the piezoelectric layer; and
the resonator further comprises an additional gap layer provided between the third electrode and the fourth electrode in the thickness direction of the resonator, the third electrode and the fourth electrode are electrically connected to each other at an additional electrical connection portion, the additional electrical connection portion defines at least part of a boundary of the additional gap layer, and the additional electrical connection portion is located outside the active region in the transverse direction of the resonator.

17. The resonator according to any one of claims 1-16, wherein the gap layer is an air gap layer or a vacuum gap layer.

18. The resonator according to any one of claims 1-16, wherein the gap layer has a thickness in a range of 50 Å to 10000 Å.

19. The resonator according to claim 18, wherein the thickness of the gap layer is in a range of 100 Å to 5000 Å.

20. A filter, comprising the bulk acoustic wave resonator according to any one of claims 1-19.

21. An electronic device, comprising the filter according to claim 20 or the resonator according to any one of claims 1-19.
